(19) Europäisches Patentamt
European Patent Office
Office européen des brevets

(11) EP 3 063 762 B1

(12) **EUROPÄISCHE PATENTSCHRIFT**

(45) Veröffentlichungstag und Bekanntmachung des Hinweises auf die Patenterteilung:
**04.07.2018 Patentblatt 2018/27**

(21) Anmeldenummer: **14795986.0**

(22) Anmeldetag: **28.10.2014**

(51) Int Cl.:
***G11B 7/245*** *(2006.01)* ***G11B 7/2535*** *(2013.01)*

(86) Internationale Anmeldenummer:
**PCT/EP2014/073080**

(87) Internationale Veröffentlichungsnummer:
**WO 2015/063064 (07.05.2015 Gazette 2015/18)**

(54) **VERBUND UMFASSEND EIN SUBSTRAT UND EINEN PHOTOPOLYMERFILM**
COMPOSITE COMPRISING A SUBSTRATE AND A PHOTOPOLYMER FILM
COMPOSITE COMPRENANT UN SUBSTRAT ET UN FILM PHOTOPOLYMÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.10.2013 EP 13190911**

(43) Veröffentlichungstag der Anmeldung:
**07.09.2016 Patentblatt 2016/36**

(73) Patentinhaber: **Covestro Deutschland AG**
**51373 Leverkusen (DE)**

(72) Erfinder:
- **WEISER, Marc-Stephan**
**51377 Leverkusen (DE)**
- **BERNETH, Horst**
**51373 Leverkusen (DE)**
- **BRUDER, Friedrich-Karl**
**47802 Krefeld (DE)**
- **RÖLLE, Thomas**
**51381 Leverkusen (DE)**
- **HÖNEL, Dennis**
**53909 Zülpich-Wichterich (DE)**
- **FÄCKE, Thomas**
**51375 Leverkusen (DE)**

(74) Vertreter: **Levpat**
**c/o Covestro AG**
**Gebäude 4825**
**51365 Leverkusen (DE)**

(56) Entgegenhaltungen:
**EP-A1- 1 803 552**
**WO-A1-2010/037515**
**JP-A- 2010 240 994**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 063 762 B1

**Beschreibung**

Die vorliegende Erfindung betrifft einen Verbund umfassend ein Substrat und einen Photopolymerfilm, die zumindest abschnittsweise lösbar miteinander verbunden sind, wobei das Substrat Polyethylenterephthalat und der Photopolymerfilm dreidimensional vernetzte Polyurethanmatrixpolymere, ein Schreibmonomer und einen Photoinitiator enthält. Weitere Gegenstände der Erfindung sind ein Verfahren zur Herstellung des erfindungsgemäßen Verbunds und ein Verfahren zur Herstellung eines isolierten Photopolymerfilms.

Ein Verbund der eingangs genannten Art ist beispielsweise aus der WO 2011/067057 bekannt. Dort wird beschrieben eine Photopolymer-Formulierung bereit zu stellen, die dreidimensional vernetzte Polyurethanmatrixpolymere, ein Schreibmonomer und einen Photoinitiator enthält. Diese Formulierung wird dann auf ein Substrat aufgebracht und ausgehärtet, wobei sie einen Photopolymerfilm bildet. Als Substrat werden unter anderem Folien aus Polyethylenterephthalat vorgeschlagen.

Nachteil des bekannten Verbundes ist allerdings, dass eine sehr starke Haftung zwischen Substrat und Photopolymerfilm besteht. Ein Lösen des Photopolymerfilms vom Substrat ist daher nur unter Aufwendung hoher Abzugskräfte möglich, wobei es in vielen Fällen zu einer Beschädigung des Photopolymerfilms kommen kann. Ein zerstörungsfreies Ablösen des belichteten Photopolymerfilms vom Substrat ist jedoch vor allem für dessen Integration in Vorrichtungen wie Sicherheitsdokumente oder Displayeinrichtungen von wesentlicher Bedeutung.

Eine theoretische Lösung dieses Problems, wäre eine Erhöhung der Dicke des Photopolymerfilms, da derartige Filme den hohen Abzugskräften besser widerstehen könnten. Allerdings sind für die meisten Anwendungen Photopolymerfilme mit möglichst geringer Schichtdicke gewünscht bzw. notwendig, so dass es sich hierbei in den allermeisten Fällen nicht um einen gangbaren Weg handelt.

Alternativ könnte versucht werden die Haftung zwischen Substrat und Photopolymerfilm zu verringern. Dazu könnten Substrate mit geringer Oberflächenspannung verwendet werden. Hier ergeben sich jedoch neue Probleme, da es nur noch unter Zusatz größerer Mengen die Oberflächenspannung stark absenkender Additive zu der Photopolymerformulierung möglich ist, einen Photopolymerfilm mit ausreichender Oberflächenbeschaffenheit herzustellen. Beim Einsatz entsprechender Mengen derartiger Additive tritt aber in vielen Fällen bereits eine Trübung der Formulierung auf. Im schlimmsten Fall kommt es sogar zu einer Entmischung der Komponenten. Werden hingegen kleinere Mengen der Additive verwendet, gelingt nur eine teilweise Benetzung des Substrates mit der Photopolymerformulierung. Im Ergebnis erhält man dann auch Photopolymerfilme, die das Substrat unvollständig bedecken. Je nach Oberflächenspannung des Substrates ist aber selbst unter Einsatz großer Mengen von Oberflächenadditiven keine geschlossene Beschichtung in den gewünschten Schichtstärken mehr zu erreichen. Mit Hilfe derartiger Formulierungen können somit keine brauchbaren Photopolymerfilmen erhalten werden.

WO 2010/037515A1 offenbart Medien für volumenholographische Aufzeichnungen basierend auf sich selbstentwickelnden Filmen.

JP 2010 240944A offenbart Hologramm-Transferfolien.

Aufgabe der vorliegenden Erfindung war es daher einen Verbund umfassend ein Substrat und einen Photopolymerfilm bereit zu stellen, bei dem das Substrat und der Photopolymerfilm leicht und vor allem ohne Beschädigung des Photopolymerfilms voneinander lösbar sind. Gleichzeitig sollte der Gehalt an Oberflächenadditiven bei der für die Herstellung des Photopolymerfilms verwendeten Photopolymerformulierung nicht höher als 1,5 Gew.-%, bevorzugt nicht höher als 1,0 Gew.-% sein, um eine Beeinträchtigung der optischen Qualität des Photopolymerfilms zu vermeiden.

Diese Aufgabe wurde dadurch gelöst, dass ein Substrat verwendet wurde, welches nach einer siebentägigen Inkubation bei 23° C in einer 0,5 volumenprozentigen Butylacetat-Lösung des Farbstoffs der Formel (I)

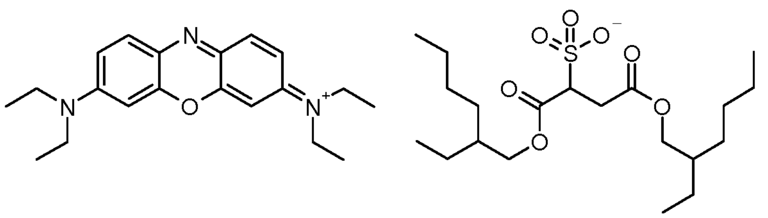

Formel (I)

einen L-Wert L1 und vor der Inkubation einen L-Wert von L0 aufweist, wobei die L-Werte durch CieLAB-Messungen bestimmt sind und bei dem die Differenz der L-Werte L1 und L0 der Formel (II)

$$L1\text{-}L0 < -0{,}25 \qquad \text{(Formel II)}$$

genügt.

So wurde überraschenderweise gefunden, dass einem Verbund aus dem Photopolymerfilm und einem Polyethylenterephthalat-Substrat, dessen L-Werte der Formel (II) genügen, eine leichte Ablösbarkeit gegeben ist, ohne dass eine chemische Modifikation der für die Herstellung des Photopolymerfilms verwendeten Formulierung mit Oberflächenadditiven erforderlich ist.

Der Farbstoff der Formel (I) Basic Blue 3 Bis-(2-ethylhexyl)sulfosuccinat kann hergestellt werden, indem Basic Blue 3, das beispielsweise als Nitrat vorliegt, mit Na-bis(2-ethylhexyl)sulfosuccinat umgesetzt wird. Dabei erfolgt ein Anionenaustausch und Basic Blue 3 Bis-(2-ethylhexyl)sulfosuccinat kann isoliert werden. Diese Umsetzung kann beispielsweise in Wasser oder Alkoholen wie Methanol oder Mischungen davon durchgeführt werden. Sie erfolgt jedoch vorteilhaft in einem Zweiphasengemisch aus Wasser und Butylacetat. Der gewünschte Farbstoff Basic Blue 3 Bis-(2-ethylhexyl)sulfosuccinat geht dabei in die organische Phase über und kann, falls gewünscht, aus dieser isoliert werden. Vorteilhafter ist es jedoch, die Lösung von Basic Blue 3 Bis-(2-ethylhexyl)sulfosuccinat in Butylacetat nach Entfernen von gelöstem Wasser direkt zu verwenden.

Die Erfindung ist durch die angefügten Ansprüche definiert.

Gemäß einer ersten bevorzugten Ausführungsform der Erfindung ist vorgesehen, dass die Differenz der L-Werte L1 und L0 der Formel (III)

$$L1\text{-}L0 \leq -0{,}30 \qquad \text{(Formel III)}$$

genügt.

Ebenfalls bevorzugt ist, wenn das Substrat eine Polyethylenterephthalat-Folie und insbesondere eine Folie mit einer Dicke von 10 μm bis 375 μm, bevorzugt von 19 μm bis 175 μm und besonders bevorzugt von 30 μm bis 100 μm ist.

Der Photopolymerfilm kann insbesondere eine Dicke von 1 μm bis 100 μm, bevorzugt von 5 μm bis 50 μm und besonders bevorzugt von 10 μm bis 28 μm aufweisen.

In Weiterbildung der Erfindung ist vorgesehen, dass der Photopolymerfilm von dem Substrat mit einer Abzugskraft von 0,05 bis 0,75 N/10 mm, bevorzugt von 0,08 bis 0,5 N/ 10 mm und besonders bevorzugt von 0,1 bis 0,25 N/ 10 mm ablösbar ist, wobei die Abzugskraft gemäß DIN-Norm EN ISO 11339 gemessen ist.

Bei einer weiteren bevorzugten Ausführungsform der Erfindung kann das Substrat eine Oberflächenspannung von > 27 mN/m, bevorzugt von ≥ 28 mN/m und ≤ 42,5 mN/m und besonders bevorzugt von ≥ 30 mN/m und ≤ 40 mN/m aufweisen. Die Oberflächenspannung wird dabei gemäß der im experimentellen Teil beschriebenen Methode gemessen.

Vorteilhaft ist auch, wenn das Substrat eine Oberflächenrauigkeit von Rz ≤ 600 nm, bevorzugt von Rz ≤ 400 nm und besonders bevorzugt von Rz ≤ 300 nm aufweist. Die Messung der Oberflächenspannung erfolgt gemäß der im experimentellen Teil beschriebenen Methode.

Bevorzugt ist auch, wenn das Substrat optisch transparent ausgebildet ist.

In den Photopolymerfilm kann insbesondere ein Hologramm einbelichtet sein. Bevorzugt kann es sich dabei um ein Volumenhologramm handeln. Dies kann ein Reflektions-, ein Transmissions- oder ein Edgelit Hologramm sein. Die Einbelichtung kann mit einem monochromatischen Laser durchgeführt werden, wobei mittels eines durch einen Strahlteiler und einer Aufweitung des Laserstrahls ein Interferenzfeld erzeugt wird. Der Laser kann dabei verschiedenen Farben (Lichtfrequenzen) erzeugen, wobei vorzugsweise eine blaue, rote, grüne oder gelbe Emissionswellenlänge verwendet werden kann. Ebenfalls möglich ist gleichzeitig oder nacheinander verschiedenfarbige Laser zu verwenden. Auf diesem Weg ist es insbesondere möglich zwei- oder mehrfarbige Reflektionshologramme zu erzeugen.

In den Photopolymerfilm können auch ein oder mehrere Hologramme an derselben Stelle oder nebeneinander einbelichtet werden. Belichtet man an derselben Stelle ein, so können unterschiedliche Bildinhalte einbelichtet werden. Es können auch verschiedene Ansichten eines Objektes mit leicht variierenden Rekonstruktionswinkeln einbelichtet werden, so dass Stereogramme entstehen. Möglich ist auch versteckte Hologramme und Mikrotexte einzubelichten. Gleichermaßen ist es im Falle von Transmissionshologrammen möglich mehrere lichtleitende Funktionen und / oder lichtleitende Funktionen für verschiedene spektrale Bereiche einzubelichten.

Die dreidimensional vernetzten Polyurethanmatrixpolymere sind insbesondere durch Umsetzung wenigstens einer Polyisocyanat-Komponente a) und wenigstens einer isocyanatreaktiven Komponente b) erhältlich.

Die Polyisocyanat-Komponente a) umfasst wenigstens eine organische Verbindung mit wenigstens zwei NCO-Gruppen. Bei diesen organischen Verbindungen kann es sich insbesondere um monomere Di- und Triisocyanate, Polyisocyanate und / oder NCOfunktionelle Prepolymere handeln. Die Polyisocyanat-Komponente a) kann auch Mischungen monomerer Di- und Triisocyanate, Polyisocyanate und / oder NCOfunktioneller Prepolymere enthalten oder daraus bestehen.

Als monomere Di- und Triisocyanate können alle dem Fachmann an sich gut bekannten Verbindungen oder deren Mischungen eingesetzt werden. Diese Verbindungen können aromatische, araliphatische, aliphatische oder cycloaliphatische Strukturen aufweisen. In untergeordneten Mengen können die monomeren Di- und Triisocyanate auch

Monoisocyanate, d.h. organische Verbindungen mit einer NCO-Gruppe umfassen.

Beispiele für geeignete monomere Di- und Triisocyanate sind 1,4-Butandiisocyanat, 1,5-Pentandiisocyanat, 1,6-Hexandiisocyanat (Hexamethylendiisocyanat, HDI), 2,2,4-Trimethylhexamethylendiisocyanat und / oder 2,4,4-Trimethylhexamethylendiisocyanat (TMDI), Isophorondiisocyanat (IPDI), 1,8-Diisocyanato-4-(isocyanatomethyl)-octan, Bis-(4,4'-isocyanatocyclohexyl)methan und / oder Bis-(2',4-isocyanatocyclohexyl)methan und / oder deren Mischungen beliebigen Isomerengehalts, 1,4-Cyclohexandiisocyanat, die isomeren Bis-(isocyanatomethyl)cyclohexane, 2,4- und / oder 2,6-Diisocyanato-1-methylcyclohexan (Hexahydro-2,4- und / oder 2,6-toluylendiisocyanat, $H_6$-TDI), 1,4-Phenylendiisocyanat, 2,4- und / oder 2,6-Toluylendiisocyanat (TDI), 1,5-Naphthylendiisocyanat (NDI), 2,4'- und / oder 4,4'-Diphenylmethandiisocyanat (MDI), 1,3-Bis(isocyanatomethyl)benzol (XDI) und / oder das analoge 1,4-Isomere oder beliebige Mischungen der vorgenannten Verbindungen.

Geeignete Polyisocyanate sind Verbindungen mit Urethan-, Harnstoff-, Carbodiimid-, Acylharnstoff-, Amid-, Isocyanurat-, Allophanat-, Biuret-, Oxadiazintrion-, Uretdion- und/oder Iminooxadiazindionstrukturen, die aus den vorgenannten Di- oder Triisocyanaten erhältlich sind.

Besonders bevorzugt handelt es sich bei den Polyisocyanaten um oligomerisierte aliphatische und / oder cycloaliphatische Di- oder Triisocyanate, wobei insbesondere die oben stehenden aliphatischen und / oder cycloaliphatischen Di- oder Triisocyanate verwendet werden können.

Ganz besonders bevorzugt sind Polyisocyanate mit Isocyanurat-, Uretdion- und / oder Iminooxadiazindion-Strukturen sowie Biurete basierend auf HDI oder deren Mischungen.

Geeignete Prepolymere enthalten Urethan- und / oder Harnstoff-Gruppen sowie gegebenenfalls weitere durch Modifizierung von NCO-Gruppen entstandene Strukturen wie oben genannt. Derartige Prepolymere sind beispielsweise durch Umsetzung der oben genannten monomeren Di- und Triisocyanate und / oder Polyisocyanaten a1) mit isocyanatreaktiven Verbindungen b1) erhältlich.

Als isocyanatreaktive Verbindungen b1) können Alkohole, Amino oder MercaptoVerbindungen, bevorzugt Alkohole, verwendet werden. Dabei kann es sich insbesondere um Polyole handeln. Ganz besonders bevorzugt können als isocyanatreaktive Verbindung b1) Polyester-, Polyether-, Polycarbonat-, Poly(meth)acrylat- und/oder Polyurethan-Polyole verwendet werden.

Als Polyesterpolyole sind beispielsweise lineare Polyesterdiole oder verzweigte Polyesterpolyole geeignet, die in bekannter Weise durch Umsetzung von aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden können. Beispiele für geeignete Di- bzw. Polycarbonsäuren sind mehrwertige Carbonsäuren wie Bernstein-, Adipin-, Kork-, Sebacin-, Decandicarbon-, Phthal-, Terephthal-, Isophthal-Tetrahydrophthal- oder Trimellithsäure sowie Säureanhydride wie Phthal-, Trimellith- oder Bernsteinsäureanhydrid oder deren beliebige Gemische untereinander. Die Polyesterpolyole können auch auf natürlichen Rohstoffen wie Rizinusöl basieren. Es ist ebenfalls möglich, dass die Polyesterpolyole auf Homo- oder Mischpolymerisaten von Lactonen basieren, die bevorzugt durch Anlagerung von Lactonen bzw. Lactongemischen wie Butyrolacton, ε-Caprolacton und / oder Methyl-ε-caprolacton an hydroxyfunktionelle Verbindungen wie mehrwertige Alkohole einer OH-Funktionalität $\geq 2$ beispielsweise der nachstehend genannten Art erhalten werden können.

Beispiele für geeignete Alkohole sind alle mehrwertigen Alkohole wie z.B. die $C_2$ - $C_{12}$-Diole, die isomeren Cyclohexandiole, Glycerin oder deren beliebige Gemische untereinander.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkohole einer OH-Funktionalität $\geq 2$, bevorzugt Butandiol-1,4, Hexandiol-1,6 und / oder 3-Methylpentandiol. Auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin sowie ihre beliebigen Mischungen.

Als Starter können die an sich im Rahmen der Polyesterpolyole genannten mehrwertigen Alkohole einer OH-Funktionalität $\geq 2$ sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden. Besonders bevorzugt sind Propylenoxid-homopolymere sowie statistische oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten $C_3$- und $C_4$-Isomere.

Daneben sind als Bestandteile der Polyol-Komponente b1) als polyfunktionelle, isocyanatreaktive Verbindungen auch niedermolekulare, d.h. mit Molekulargewichten ≤ 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise in Ergänzung zu den oben genannten Verbindungen Neopentylglykol, 2-Ethyl-2-butylpropandiol, Trimethylpentandiol, stellungs-isomere Diethyloctandiole, Cyclohexandiol, 1,4-Cyclohexandimethanol, 1,6-Hexandiol, 1,2- und 1,4-Cyclohexandiol, hydriertes Bisphenol A, 2,2-Bis(4-hydroxy-cyclohexyl)-propan oder 2,2-Dimethyl-3-hydroxypropionsäure, 2,2-dimethyl-3-hydroxypropyl-ester sein. Beispiele geeigneter Triole sind Trimethylolethan, Trimethylolpropan oder Glycerin. Geeignete höherfunktionelle Alkohole sind Di-(trimethylolpropan), Pentaerythrit, Dipenta-erythrit oder Sorbit.

Besonders bevorzugt ist, wenn die Polyolkomponente ein difunktioneller Polyether-, Polyester- oder ein Polyether-polyester-block-copolyester oder ein Polyether-Polyester-Blockcopolymer mit primären OH-Funktionen ist.

Es ist ebenfalls möglich, als isocyanatreaktive Verbindungen b1) Amine einzusetzen. Beispiele geeigneter Amine sind Ethylendiamin, Propylendiamin, Diaminocyclohexan, 4,4'-Dicyclohexylmethandiamin, Isophorondiamin (IPDA), difunktionelle Polyamine wie z.B. die Jeffamine®, aminterminierte Polymere, insbesondere mit zahlenmittleren Molmassen ≤ 10000 g/Mol. Mischungen der vorgenannten Amine können ebenfalls verwendet werden.

Es ist ebenfalls möglich, als isocyanatreaktive Verbindungen b1) Aminoalkohole einzusetzen. Beispiele geeigneter Aminoalkohole sind die isomeren Aminoethanole, die isomere Aminopropanole, die isomeren Aminobutanole und die isomeren Aminohexanole oder deren beliebige Mischungen.

Alle vorgenannten isocyanatreaktiven Verbindungen b1) können untereinander beliebig vermischt werden.

Bevorzugt ist auch, wenn die isocyanatreaktiven Verbindungen b1) eine zahlenmittlere Molmasse von ≥ 200 und ≤ 10000 g/Mol, weiter bevorzugt ≥ 500 und ≤ 8000 g/Mol und ganz besonders bevorzugt ≥ 800 und ≤ 5000 g/Mol aufweisen. Die OH-Funktionalität der Polyole beträgt bevorzugt 1.5 bis 6.0, besonders bevorzugt 1.8 bis 4.0.

Die Prepolymere der Polyisocyanat-Komponente a) können insbesondere einen Restgehalt an freiem monomeren Di- und Triisocyanaten < 1 Gew.-%, besonders bevorzugt < 0.5 Gew.-% und ganz besonders bevorzugt < 0.3 Gew.-% aufweisen.

Es ist gegebenenfalls auch möglich, dass die Polyisocyanat-Komponente a) vollständig oder anteilsmäßig organische Verbindungen enthält, deren NCO-Gruppen ganz oder teilweise mit aus der Beschichtungstechnologie bekannten Blockierungsmitteln umgesetzt sind. Beispiele für Blockierungsmittel sind Alkohole, Lactame, Oxime, Malonester, Pyrazole sowie Amine, wie z.B. Butanonoxim, Diisopropylamin, Malonsäurediethylester, Acetessigester, 3,5-Dimethylpyrazol, ε-Caprolactam, oder deren Mischungen.

Besonders bevorzugt ist, wenn die Polyisocyanat-Komponente a) Verbindungen mit aliphatisch gebundenen NCO-Gruppen umfasst, wobei unter aliphatisch gebundenen NCO-Gruppen derartige Gruppen verstanden werden, die an ein primäres C-Atom gebunden sind. Die isocyanatreaktive Komponente b) umfasst bevorzugt wenigstens eine organische Verbindung, die im Mittel wenigstens 1.5 und bevorzugt 2 bis 3 isocyanatreaktive Gruppen aufweist. Im Rahmen der vorliegenden Erfindung werden als isocyanatreaktive Gruppen bevorzugt Hydroxy-, Amino- oder Mercapto-Gruppen angesehen.

Die isocyanatreaktive Komponente kann insbesondere Verbindungen umfassen, die im Zahlenmittel wenigstens 1.5 und bevorzugt 2 bis 3 isocyanatreaktive Gruppen aufweisen.

Geeignete polyfunktionelle, isocyanatreaktive Verbindungen der Komponente b) sind beispielsweise die oben beschriebenen Verbindungen b1).

Besonders bevorzugt ist eine Kombination aus Komponenten a) und b) bei der Herstellung der Polyurethanmatrixpolymere bestehend aus Additionsprodukten von Butyrolacton, e-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Ganz besonders bevorzugt sind Additionsprodukte von e-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

Bei einer weiteren bevorzugten Ausführungsform ist vorgesehen, dass das Schreibmonomer wenigstens ein mono- und / oder ein multifunktionales Schreibmonomer umfasst oder daraus besteht. Weiter bevorzugt kann das Schreibmonomer wenigstens ein mono- und / oder ein multifunktionelles (Meth)acrylat-Schreibmonomere umfassen oder daraus bestehen. Ganz besonders bevorzugt kann das Schreibmonomer wenigstens ein mono- und / oder ein multifunktionelles Urethan(meth)acrylat umfassen oder daraus bestehen.

Geeignete Acrylat-Schreibmonomere sind insbesondere Verbindungen der allgemeinen Formel (V)

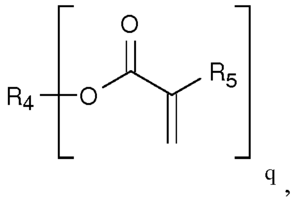

(Formel V)

bei denen q≥1 und q≤4 ist und $R^4$ ein linearer, verzweigter, cyclischer oder heterocyclischer unsubstituierter oder gegebenenfalls auch mit Heteroatomen substituierter organischer Rest und/oder $R^5$ Wasserstoff, ein linearer, verzweigter, cyclischer oder heterocyclischer unsubstituierter oder gegebenenfalls auch mit Heteroatomen substituierter organischer Rest ist. Besonders bevorzugt ist $R^5$ Wasserstoff oder Methyl und/oder $R^4$ ein linearer, verzweigter, cyclischer oder heterocyclischer unsubstituierter oder gegebenenfalls auch mit Heteroatomen substituierter organischer Rest.

Als Acrylate bzw. Methacrylate werden vorliegend Ester der Acrylsäure bzw. Methacrylsäure bezeichnet. Beispiele bevorzugt verwendbarer Acrylate und Methacrylate sind Phenylacrylat, Phenylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Bisphenol A Diacrylat, Bisphenol A Dimethacrylat, sowie deren ethoxylierte Analogverbindungen, N-Carbazolylacrylate.

Als Urethanacrylate werden vorliegend Verbindungen mit mindestens einer Acrylsäureestergruppe und mindestens eine Urethanbindung verstanden. Solche Verbindungen können beispielsweise durch Umsetzung eines Hydroxy-funktionellen Acrylats oder Methacrylats mit einer Isocyanat-funktionellen Verbindung erhalten werden.

Beispiele hierfür verwendbarer Isocyanat-funktionelle Verbindungen sind Monoisocyanate sowie die unter a) genannten monomeren Diisocyanate, Triisocyanate und / oder Polyisocyanate. Beispiele geeigneter Monoisocyanate sind Phenylisocyanat, die isomeren Methylthiophenylisocyanate. Di-, Tri- oder Polyisocyanate sind oben genannt sowie Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise Verbindungen wie 2-Hydroxyethyl(meth)acrylat, Polyethylenoxid-mono(meth)acrylate, Polypropylenoxidmono(meth)acrylate, Polyalkylen-oxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylat.

Ebenfalls verwendet werden können die an sich bekannten hydroxylgruppenhaltigen Epoxy-(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und / oder m-Methylthiophenylisocyanat mit alkoholfunktionellen Acrylaten wie Hydroxyethyl(meth)acrylat, Hydroxypropyl(meth)acrylat und / oder Hydroxybutyl(meth)acrylat.

Ebenso ist es möglich, dass das Schreibmonomer weitere ungesättigte Verbindungen wie α,β-ungesättigte Carbonsäurederivate wie beispielsweise Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol und / oder Olefine, umfasst oder daraus besteht.

Gemäß einer weiteren bevorzugten Ausführungsform ist vorgesehen, dass der Photopolymerfilm zusätzlich Urethane als Additive enthält, wobei die Urethane insbesondere mit wenigstens einem Fluoratom substituiert sein können.

Bevorzugt sind diese Urethane Urethane der allgemeinen Formel (IV),

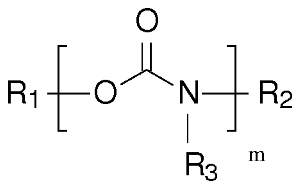

(IV)

in der m ≥ 1 und m ≤ 8 ist und $R_1$ ein linearer, verzweigter, cyclischer oder heterocyclischer unsubstituierter oder gegebenenfalls auch mit Heteroatomen substituierter organischer Rest und / oder $R_2$, $R_3$ unabhängig voneinander Wasserstoff sind, wobei bevorzugt mindestens einer der Reste $R_1$, $R_2$, $R_3$ mit wenigstens einem Fluoratom substituiert ist und besonders bevorzugt $R_1$ ein organischer Rest mit mindestens einem Fluoratom und ganz besonders bevorzugt $R_3$ ein linearer, verzweigter, cyclischer oder heterocyclischer unsubstituierter oder gegebenenfalls auch mit Heteroatomen wie beispielsweise Fluor substituierter organischer Rest ist.

Photoinitiatoren der Komponente d) sind üblicherweise durch aktinische Strahlung aktivierbare Verbindungen, die eine Polymerisation der Schreibmonomere auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation unterschieden.

Typ I-Photoinitiatoren (Norrish-Typ-I) für die radikalische Photopolymerisation bilden beim Bestrahlen durch eine unimolekulare Bindungsspaltung freie Radikale. Beispiele für Typ I-Photoinitiatoren sind Triazine, Oxime, Benzoinether, Benzilketale, Bis-imidazole, Aroylphosphinoxide, Sulfonium- und Iodoniumsalze.

Typ II-Photoinitiatoren (Norrish-Typ-II) für die radikalische Polymerisation bestehen aus einem Farbstoff als Sensibilisator und einem Coinitiator und durchlaufen bei der Bestrahlung mit auf den Farbstoff angepasstem Licht eine bimolekulare Reaktion. Zunächst absorbiert der Farbstoff ein Photon und überträgt aus einem angeregten Zustand Energie auf den Coinitiator. Dieser setzt durch Elektronen- oder Protonentransfer oder direkte Wasserstoffabstraktion die polymerisationsauslösenden Radikale frei.

Im Sinne dieser Erfindung werden bevorzugt Typ II-Photoinitiatoren verwendet.

Solche Photoinitiatorsysteme sind prinzipiell in der EP 0 223 587 A beschriebenen und bestehen bevorzugt aus einer Mischung von einem oder mehreren Farbstoffen mit Ammoniumalkylarylborat(en).

Geeignete Farbstoffe, die zusammen mit einem Ammoniumalkylarylborat einen Typ II-Photoinitiator bilden, sind die in der WO 2012062655 beschriebenen kationischen Farbstoffe in Kombination mit den eben dort beschriebenen Anionen.

Unter kationischen Farbstoffen werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Besonders bevorzugt sind Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, Nullmethin-Farbstoffe - insbesondere Naphtholactam-Farbstoffe, Streptocyanin-Farbstoffe.

Beispiele für kationische Farbstoffe sind Astrazon Orange G, Basic Blue 3, Basic Orange 22, Basic Red 13, Basic Violett 7, Methylenblau, Neu Methylenblau, Azur A, 2,4-Diphenyl-6-(4-methoxyphenyl)pyrylium, Safranin O, Astraphloxin, Brilliant Grün, Kristallviolett, Ethylviolett und Thionin.

Bevorzugte Anionen sind insbesondere $C_8$- bis $C_{25}$-Alkansulfonat, vorzugsweise $C_{13}$- bis $C_{25}$-Alkansulfonat, $C_3$- bis $C_{18}$-Perfluoralkansulfonat, $C_4$- bis $C_{18}$-Perfluoralkansulfonat, das in der Alkylkette mindestens 3 Wasserstoffatome trägt, $C_9$- bis $C_{25}$-Alkanoat, $C_9$- bis $C_{25}$-Alkenoat, $C_8$- bis $C_{25}$-Alkylsulfat, vorzugsweise $C_{13}$- bis $C_{25}$-Alkylsulfat, $C_8$- bis $C_{25}$-Alkenylsulfat, vorzugsweise $C_{13}$- bis $C_{25}$-Alkenylsulfat, $C_3$- bis $C_{18}$-Perfluoralkylsulfat, $C_4$-bis $C_{18}$-Perfluoralkylsulfat, das in der Alkylkette mindestens 3 Wasserstoffatome trägt, Polyethersulfate basierend auf mindestens 4 Äquivalenten Ethylenoxid und/oder Äquivalenten 4 Propylenoxid, Bis-$C_4$- bis $C_{25}$-Alkyl-, $C_5$- bis $C_7$-Cycloalkyl-, $C_3$- bis $C_8$-Alkenyl- oder $C_7$- bis $C_{11}$-Aralkyl-sulfosuccinat, durch mindestens 8 Fluoratome substituiertes Bis-$C_2$- bis $C_{10}$-alkylsulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$- bis $C_8$-Alkyl und/oder $C_1$- bis $C_{12}$-Alkoxycarbonyl substituiertes Benzolsulfonat, ggf. durch Nitro, Cyano,

Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, ggf. durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin- oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester, Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester, (Sulfo-$C_2$- bis $C_6$-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, $C_4$- bis $C_{12}$-Alkyl-triphenylborat, deren Phenyl- oder Phenoxy-Reste durch Halogen, $C_1$- bis $C_4$-Alkyl und/oder $C_1$- bis $C_4$-Alkoxy substituiert sein können, $C_4$- bis $C_{12}$-Alkyl-trinaphthylborat, Tetra-$C_1$- bis $C_{20}$-alkoxyborat, 7,8- oder 7,9-Dicarba-nido-undecaborat(1-) oder (2-), die gegebenenfalls an den B- und/oder C-Atomen durch eine oder zwei $C_1$- bis $C_{12}$-Alkyl- oder Phenyl-Gruppen substituiert sind, Dodecahydro-dicarbadodecaborat(2-) oder B-$C_1$- bis $C_{12}$-Alkyl-C-phenyl-dodecahydro-dicarbadodecaborat(1-) steht, wobei bei mehrwertigen Anionen wie Naphthalindisulfonat $A^-$ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl substituiert sein können.

Bevorzugt ist auch, wenn das Anion $A^-$ des Farbstoffs einen AClogP im Bereich von 1 bis 30, besonders bevorzugt im Bereich von 1 bis 12 und insbesondere bevorzugt im Bereich von 1 bis 6,5 aufweist. Der AClogP wird nach J. Comput. Aid. Mol. Des. 2005, 19, 453; Virtual Computational Chemistry Laboratory, http://www.vcclab.org berechnet.

Geeignete Ammoniumalkylarylborate sind beispielsweise (Cunningham et al., RadTech'98 North America UV/EB Conference Proceedings, Chicago, Apr. 19-22, 1998): Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat ([191726-69-9], CGI 7460, Produkt der BASF SE, Basel, Schweiz), 1-Methyl-3-octylimidazolium Dipentyldiphenylborat und Tetrabutylammonium Tris-(3-chlor-4-methylphenyl)-hexylborat ([1147315-11-4], CGI 909, Produkt der BASF SE, Basel, Schweiz).

Es kann vorteilhaft sein, Gemische dieser Photoinitiatoren einzusetzen. Je nach verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in der Photopolymer-Formulierung enthalten ist.

Weiter bevorzugt ist auch, wenn die Photopolymer-Formulierung für wenigstens zwei Laserlichtfarben ausgewählt aus blau, grün und rot je einen geeigneten Photoinitiator enthält.

Ganz besonders bevorzugt ist schließlich, wenn die Photopolymer-Formulierung für jede der Laserlichtfarben blau, grün und rot jeweils einen geeigneten Photoinitiator enthält.

Ein weiterer Gegenstand der vorliegenden Erfindung ist ein Verfahren zur Herstellung eines erfindungsgemäßen Verbundes bei dem eine Photopolymerformulierung umfassend eine Polyisocyanat-Komponente, eine isocyanatreaktive Komponente, ein Schreibmonomer und einen Photoinitiator auf das Substrat aufgebracht und zum Photopolymerfilm ausgehärtet wird.

Ebenfalls Gegenstand der Erfindung ist ein Verfahren zur Herstellung eines isolierten Photopolymerfilms, bei dem bei einem erfindungsgemäßen Verbund der Photopolymerfilm und das Substrat vollständig voneinander getrennt werden.

Auch offenbart ist ein nach dem vorstehenden Verfahren erhältlicher isolierter Photopolymerfilm.

Auch offenbart ist ein Verfahren zur Integration eines Photopolymerfilms, bei dem ein isolierter Photopolymerfilm in eine Vorrichtung integriert wird.

Gemäß einer Ausführungsform des vorstehenden Verfahrens kann es sich bei der Vorrichtung um ein Display oder ein Sicherheitsdokument handeln.

Die Erfindung wird im Folgenden anhand von Beispielen näher erläutert.

## Beispiele

### Messmethoden:

#### Messung der Trockenschichtdicke der Photopolymerfilms

Die physikalische Schichtdicke wurde mit marktgängigen Weisslichtinterferometern, wie z.B. das Gerät FTM-Lite NIR Schichtdickenmessgerät der Firma Ingenieursbüro Fuchs, ermittelt.

Die Bestimmung der Schichtdicke beruht im Prinzip auf Interferenzerscheinungen an dünnen Schichten. Dabei überlageren sich Lichtwellen, die an zwei Grenzflächen unterschiedlicher optischer Dichte reflektiert worden sind. Die ungestörte Überlagerung der reflektierten Teilstrahlen führt zur periodischen Aufhellung und Auslöschung im Spektrum eines weißen Kontinuumstrahlers (z.B. Halogenlampe). Diese Überlagerung nennt der Fachmann Interferenz. Die Interferenzspektren wurden gemessen und mathematisch ausgewertet.

#### Festgehalt

Ca. 1g der jeweiligen Probe wurde in einem unlackierten Dosendeckel aufgetragen und mittels einer Büroklammer gut verteilt. Dosendeckel und Büroklammer wurden zuvor gewogen. Die Probe mit Büroklammer und Dosendeckel wurden dann eine Stunde bei 125°C in einem Ofen getrocknet. Der Festgehalt ergab sich: (Auswaage-Tara)*100 / (Einwaage-Tara).

#### Viskosität

Die Viskositäten wurden nach DIN EN ISO 3219/A.3 bei 23 °C und einer Scherrate von 40 $s^{-1}$ bestimmt.

#### Isocyanatgehalt (NCO-Gehalt)

Die NCO-Werte (Isocyanat-Gehalte) wurden gemäß DIN EN ISO 11909 bestimmt.

#### Herstellung der Prüfmuster für die LAB-Messung:

Von den zu untersuchenden Substraten wurden jeweils zwei Folienproben der ungefähren Größe 2 cm x 3 cm zugeschnitten. Eine Folienprobe wurde dann in einer 0,5 volumenprozentigen Butylacetat-Lösung C. I. Basic Blue 3 als Bis-(2-ethylhexyl)sulfousuccinat 7 Tage bei 23 °C inkubiert. Danach wurden die Probe aus der Lösung genommen, mit einem Papiertuch trocken getupft und an der Luft getrocknet.

#### Messung des L-Wertes gemäß CIELAB-System

Die Messungen wurden auf einem Kugelspektrometer vom Typ Hunter Ultrascan Pro von Hunter Lab, FMS Jansen GmbH & Co. KG, Murnau am Staffelsee, Deutschland in Anlehnung an die Norm ASTM E 308 für L*a*b* durchgeführt. Zur Messung wurde die Lampenart D65 und ein Beobachtungswinkel von 10° verwendet. Der Messbereich reichte von 350 nm- 1100 nm, wobei für die farbmetrische Bestimmung nur bis 850 nm gemessen wurde. Zur Eichung wurde eine Messung an Luft durchgeführt und die Transmission dieser Messung auf 100% gesetzt.

Für jedes zu untersuchende Substrat wurde einerseits der Wert L0 der nicht inkubierten Folienprobe sowie der Wert L1 der inkubierten Folienprobe bestimmt.

Anschließend wurde die Differenz der Werte L1 und L0 gebildet. War diese kleiner oder gleich -0,25 wurde das Substrat als erfindungsgemäß geeignet eingestuft.

#### Messung der Oberflächenspannung $\sigma$ an Substraten

Die Messung erfolgte mit einem Messgeräts des Typs OCA 20 der Firma DataPhysics Instruments GmbH, Filderstadt, Deutschland. Die Oberflächenspannung wurde gemäß der Methode von Owens-Wendt über die Software SCA21 aus den Kontaktwinkeln berechnet. Zur Messung der Kontaktwinkel wurden jeweils 3 $\mu$l einer Messflüssigkeit auf das zu untersuchende Substrat aufgebracht. Eine USB-CCIR Kamera nahm mit einer Frequenz von 20 Bildern pro Sekunde Bilder des Tropfens auf. 4 Sekunden nach Auftragung des Tropfens erfolgte automatisiert die Auswertung des Kontaktwinkels. Es wurden mindestens 5 Einzelmessungen pro Substrat und Messflüssigkeit durchgeführt um eine ausreichende statistische Grundlage zu erhalten. Als Messflüssigkeiten wurden zweifach destilliertes Wasser, frisches Diiodmethan und Ethylenglykol verwendet.

Die gerätspezifische Messgenauigkeit des Kontaktwinkels lag nach Herstellerangabe bei ± 0,1°.

**Messung der Abzugskräfte**

Die Messung erfolgte mit einer Zugprüfmaschine gemäß DIN EN ISO 527-1. Gemessen wurden Zugkraft und Fahrweg der Zugtraverse. Die Zugkraft wurde als Schäl- bzw. Klebkraft und der Traversenweg als Schälweg definiert, grafisch dargestellt als Zugkraft-Schälweg Diagramm. Die Klebkraft war der Mittelwert der Zugkräfte zwischen 20 und 100 mm Schälweg. Gemäß DIN EN ISO 11339 (180°-Schälversuch, T-Schälversuch) war die Schälfestigkeit definiert als Schälkraft bezogen auf die gesamte Probenbreite. Die Probe war mindestens 80 mm lang, die Einspannlänge in den Spannklemmen ist 20 mm. Der Schälweg betrug 60 mm, entsprechend einem Fahrweg der Zugtraverse von 120 mm. Die Zuggeschwindigkeit war 100 mm/min. Die Zugkraft wurde mit einem 50 N Kraftaufnehmer gemessen.

**Einsatzstoffe:**

**Übersicht über die verwendeten Substrate:**

**Substratfolie 1** ist Hostaphan GN 50 CT01B ($\sigma$ = 37,9 mN/m) und wurde von Mitsubishi Polyester Film GmbH, Wiesbaden, Deutschland, bezogen.

**Substratfolie 2** ist Excell XG 532 ($\sigma$ = 38,5 mN/m) und wurde von Toray International Europe GmbH, Neu-Isenburg, Deutschland, bezogen.

**Substratfolie 3** ist Excell XG6SF2 ($\sigma$ = 36,9 mN/m) und wurde von Toray International Europe GmbH, Neu-Isenburg, Deutschland, bezogen.

**Substratfolie 4** ist Lumirror U32 ($\sigma$ = 36,4 mN/m) und wurde von Toray International Europe GmbH, Neu-Isenburg, Deutschland, bezogen.

**Substratfolie 5** ist Lumirror U40 ($\sigma$ = 37,3 mN/m) und wurde von Toray International Europe GmbH, Neu-Isenburg, Deutschland, bezogen.

**Substratfolie V1** ist Hostaphan RNK 36 ($\sigma$ = 48,3 mN/m) und wurde von Mitsubishi Polyester Film GmbH, Wiesbaden, Deutschland, bezogen.

**Einsatzstoffe für die Photopolymerfilme:**

**Komponente A:** experimentelles Produkt der Bayer MaterialScience AG, Leverkusen, Deutschland, die Herstellung ist unten beschrieben.

**Komponente B1 (Phosphorthioyltris(oxy-4,1-phenyleniminocarbonyloxyethan-2,1-diyl)-triacrylat):** experimentelles Produkt der Bayer MaterialScience AG, Leverkusen, Deutschland, die Herstellung ist unten beschrieben.

**Komponente B2 (2-({[3-(Methylsulfanyl)phenyl]carbamoyl}oxy)ethylprop-2-enoat):** experimentelles Produkt der Bayer MaterialScience AG, Leverkusen, Deutschland, die Herstellung ist unten beschrieben.

**Komponente C (Bis(2,2,3,3,4,4,5,5,6,6,7,7-dodecafluorheptyl)- (2,2,4-trimethylhexan-1,6-diyl) biscarbamat):** experimentelles Produkt der Bayer MaterialScience AG, Leverkusen, Deutschland, die Herstellung ist unten beschrieben.

**Komponente D:** Fascat 4102 0,07 %, Urethanisierungskatalysator, Butylzinn-tris(2-ethylhexanoat), Produkt der Arkema GmbH, Düsseldorf, Deutschland.

**BYK® 310:**silikonbasiertes Oberflächenadditiv der Firma BYK-Chemie GmbH, Wesel, 25%ige Lösung in Xylol

**Komponente E:** C. I. Basic Blue 3 (umgesalzt als Bis-(2-ethylhexyl)sulfosuccinat) 0,26 %, Safranin O (umgesalzt als Bis-(2-ethylhexyl)sulfosuccinat) 0,13 % und Astrazon Orange G (umgesalzt als Bis-(2-ethylhexyl)sulfosuccinat) 0,13% mit CGI 909, Versuchsprodukt der Fa. BASF SE, Basel, Schweiz, 1,5%, als Lösung in 5,8% Ethylacetat gelöst. Prozentgehalte beziehen sich auf die Gesamtformulierung des Mediums.

**Komponente F:** Ethylacetat (CAS-Nr. 141-78-6).

**Komponente G:** Desmodur® N 3900, Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 %.

**Herstellungsvorschriften der Einsatzstoffe:**

**Herstellung von Komponente A:**

In einem 1 L Kolben wurden 0,18 g Zinnoktoat, 374.8 g $\varepsilon$-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder

darüber lag. Anschließend wurde abgekühlt und das Produkt als wachsartiger Feststoff erhalten.

**Herstellung von Komponente B1 (Phosphorthioyltris(oxy-4,1-phenyleniminocarbonyl-oxyethan-2,1-diyl)-triacrylat):**

In einem 500 mL Rundkolben wurden 0,1 g 2,6-Di-tert.-butyl-4-methylphenol, 0,05 g Dibutylzinn-dilaurat (Desmorapid® Z, Bayer MaterialScience AG, Leverkusen, Deutschland) und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0,1 % gesunken war. Danach wurde abgekühlt und im Vakuum das Ethylacetat vollständig entfernt. Das Produkt wurde als teilkristalliner Feststoff erhalten.

**Herstellung von Komponente B2 (2-({[3-(Methylsulfanyl)phenyl]carbamoyl}oxy)ethyl-prop-2-enoat):**

In einem 100 mL Rundkolben wurden 0,02 g 2,6-Di-tert.-butyl-4-methylphenol, 0,01 g Desmorapid® Z, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0,1 % gesunken war. Danach wurde abgekühlt. Das Produkt wurde als hellgelbe Flüssigkeit erhalten.

**Herstellung des Additives C (Bis(2,2,3,3,4,4,5,5,6,6,7,7-dodecafluorheptyl)-(2,2,4-trimethylhexan-1,6-diyl)biscarbamat):**

In einem 2000 mL Rundkolben wurden 0,02 g Desmorapid® Z und 3,60 g 2,4,4-Trimethylhexane-1,6-diisocyanat (TMDI) vorgelegt und auf 70 °C erwärmt. Anschließend wurden 11,39 g 2,2,3,3,4,4,5,5,6,6,7,7-Dodecafluorheptan-1-ol zugetropft und die Mischung weiter auf 70 °C gehalten, bis der Isocyanatgehalt unter 0,1 % gesunken war. Danach wurde abgekühlt. Das Produkt wurde als farbloses Öl erhalten.

**Herstellung von Basic Blue 3-Bis(2-ethylhexyl)sulfosuccinat**

15,0 g Natrium-bis(2-ethylhexyl)sulfosuccinat wurden in 350 ml Wasser bei 50 °C gelöst. 24,5 g des Farbstoffs der Formel

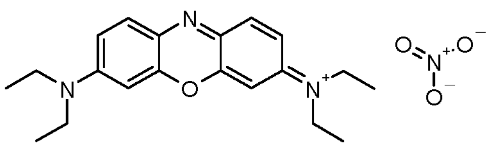

,

(Basic Blue 3), als 53 Gew.-%. Ware und 220 ml Essigsäurebutylester wurden zugesetzt und es wurde 4 h bei 50 °C gerührt. Die wässrige Phase wurde abgetrennt und die organische Phase dreimal mit 50 ml frischem Wasser bei 50 °C verrührt. Schließlich wurde jedes Mal die wässrige Phase abgetrennt, die letzte bei Raumtemperatur. Die tiefblaue organische Phase wurde mit wasserfreiem Magnesiumsulfat vorgetrocknet, filtriert und durch azeotrope Destillation bei 150 mbar vom Restwasser befreit. Durch Zusatz von wasserfreiem Essigsäurebutylester wurden schließlich 250 g tiefblaue Lösung hergestellt, die 9,68 Gew.-% an dem Farbstoff der Formel

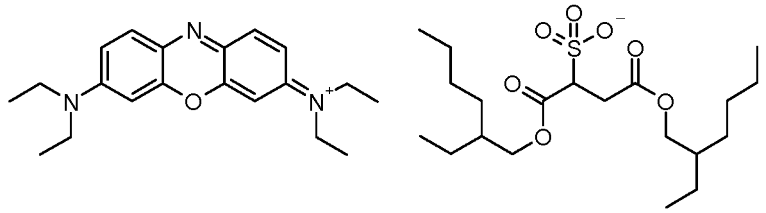

enthielt (96,4 % d. Th.).

$\lambda_{max}$ in Methanol: 643 nm.

Diese Lösung konnte nach entsprechender Verdünnung direkt zur erfindungsgemäßen Prüfung verwendet werden.

**Herstellung der Verbünde aus Substrat und Photopolymerfilm auf einer Folienbeschichtungsanlage**

Zur Herstellung wurde die in Figur 1 dargestellte Folienbeschichtungsanlage verwendet, wobei den einzelnen Bauteilen die folgenden Bezugszeichen zugeordnet sind:

1 Erster Vorratsbehälter

1' Zweiter Vorratsbehälter

2 Dosiereinrichtung

3 Vakuumentgasungseinrichtung

4 Filter

5 Statischer Mischer

6 Beschichtungseinrichtung

7 Umlufttrockner

8 Substratfolie

9 Abdeckschicht

Zur Herstellung einer Photopolymer-Formulierung wurden in einem Rührbehälter 304,3g Komponente A schrittweise mit einer Schreibmonomermischung aus 138g Komponente B1 und 138g Komponente B2, mit 191g Additiv C, 0,60g Komponente D, 2,55g BYK® 310 und 101g Komponente F versetzt und gemischt. Anschließend wurden 66,5g Komponente E der Mischung im Dunklen hinzugefügt und vermischt, so dass eine klare Lösung erhalten wurde. Wenn nötig, wurde die Formulierung für kurze Zeit bei 60 °C erwärmt, um die Einsatzstoffe schneller in Lösung zu bringen.

Dieses Gemisch wurde anschließend in den ersten Vorratsbehälter 1 der Beschichtungsanlage eingebracht. In den zweiten Vorratsbehälter 1' wurde die Komponente G (Polyisocyanat) eingefüllt. Beide Komponenten wurden dann jeweils durch die Dosiereinrichtungen 2 im Verhältnis von 942,2 (Komponenten A bis F) zu 57,8 (Komponente G) zur Vakuumentgasungseinrichtung 3 gefördert und entgast. Von hier aus wurden sie dann jeweils durch die Filter 4 in den statischen Mischer 5 geleitet, in dem die Vermischung der Komponenten zur Photopolymer-Formulierung erfolgte. Die erhaltene, flüssige Masse wurde dann im Dunklen der Beschichtungseinrichtung 6 zugeführt.

Bei der Beschichtungseinrichtung 6 handelte es sich im vorliegenden Fall um eine dem Fachmann bekannte Schlitzdüse. Alternativ kann aber auch ein Rakelsystem (Doctor Blade). zum Einsatz kommen. Mit Hilfe der Beschichtungseinrichtung 6 wurde die Photopolymer-Formulierung bei einer Verarbeitungstemperatur von 20 °C auf die jeweilige Substratfolie 8 appliziert und für 5,8 Minuten bei einer Vernetzungstemperatur von 80°C in einem Umlufttrockner 7 getrocknet. Dabei wurde ein Verbund in der Form eines Films erhalten, der dann mit einer 40 μm dicken Polyethylenfolie als Abdeckschicht 9 versehen und aufgewickelt wurde.

Die erzielte Schichtdicke des Films lag bei 18 μm ± 1 μm.

**Herstellung der Probekörper für die Messung der Abzugskräfte des belichteten und des unbelichteten Photopolymers**

Ist die Haftung zwischen Substratfolie und Photopolymerfilm kleiner als die zwischen Abdeckschicht und Photopolymerfilm, kann der Verbund als solches vermessen werden, ohne dass vorher die Abdeckschicht entfernt werden müsste. Dazu wurde ein Stück der Größe 10 cm x 20 cm aus dem Verbund ausgeschnitten und auf das Förderband eines UV-Strahlers gelegt und mit einer Bahngeschwindigkeit von 2,5 m/min zwei Mal belichtet. Als UV-Strahler wurde eine eisendotierte Hg-Lampe vom Typ Fusion UV type "D Bulb" No. 558434 KR 85 mit 80 W / $cm^2$ Gesamtleistungsdichte verwendet. Das Spektrum der verwendeten Lampe ist in Figur 2 abgebildet (Herstellerangabe). Die Parameter entsprechen einer Dosis von 2 x 2,0 J/$cm^2$, gemessen mit einem Light Bug des Typs ILT 490. Mit "Dosis" ist generell jeweils die tatsächlich auf den Photopolymerfilm einwirkende Lichtmenge gemeint. Anschließend wurden Streifen einer Breite von 10 mm und einer Länge von ca. 12 cm aus dem belichteten Verbund ausgeschnitten und dann an diesen Streifen gemäß der oben beschriebenen Methode die zum Abziehen der Substratfolie notwendige Kraft gemessen..

Ist die Haftung zwischen Abdeckschicht und Photopolymerfilm geringer als die zwischen Substratfolie und

Photopolymerfilm, wurde zunächst die Abdeckschicht manuell entfernt. Dann wurde ein Stück der Größe 10 cm x 20 cm aus dem Verbund, bestehend aus Photopolymerfilm und Substratfolie, ausgeschnitten, auf eine Glasplatte laminiert und wie oben beschrieben zwei Mal mit dem UV-Strahler belichtet. Anschließend wurde das Stück des Verbundes unter Verwendung eines Rollenlaminators bei 100 °C mit der Photopolymerfilmseite unter Verwendung einer Schmelzklebnefolie auf Basis eines thermoplastischen Polyurethans des Typs Platilon HU2 der Epurex Films GmbH & Co. KG, Walsrode, Deutschland, auf die glatte Seite einer Polycarbonatfolie des Typs Makrofol DE 1-4 (Produkt der Bayer MaterialScience AG, Leverkusen, Deutschland) geklebt. Anschließend wurden Streifen einer Breite von 10 mm und einer Länge von ca. 12 cm aus dem Verbund ausgeschnitten und dann an diesen Streifen gemäß der oben beschriebenen Methode die zum Abziehen der Substratfolie notwendige Kraft gemessen.

**Ergebnisse der Messungen der Abzugskräfte nach DIN EN ISO 11339:**

| Substratfolie | L1-L0 | Abzugskraft P belichtet |
|---|---|---|
| 1 | -0,75 | 0,12 * |
| 2 | -0,97 | 0,10 * |
| 3 | -0,30 | 0,15 * |
| 4 | -0,48 | 0,16 |
| 5 | -3,51 | 0,17 |
| V1 | -0,04 | 3,6 |
| Werte in N / 10 mm, * Probenmessung auf 15 mm Probenbreite. | | |

Wie aus vorstehender Tabelle hervorgeht, wurden für die Substratfolien 1-5 Abzugskräfte, die für eine Ablösung des Photopolymerfilms erforderlich sind, gemessen, die im Bereich kleiner 0,25 N / mm liegen. Dies zeigt, dass bei den Verbünden, die eine dieser Substratfolien enthalten, eine Trennung von Substratfolie und Photopolymerfilm leicht und vor allem auch ohne Beschädigung des Photopolymerfilms möglich ist.

Für die Substratfolien 1-5 wurde darüber hinaus jeweils die Differenzen des L1 und des L0 Wertes gemessen. Sie sind alle kleiner als -0,25. Hierdurch wird belegt, dass die Differenz der L-Werte und das Kriterium der Formel (II) zur Identifizierung leicht ablösbarer Substratfolien geeignet sind.

Das Vergleichsbeispiel V1 zeigt wiederum, dass dann ,wenn die Differenz von L1 und L0 großer als -0,25 ist, auch erheblich größere Abzugskräfte für eine Ablösung des Photopolymerfilms von der Substratfolie erforderlich sind. Diese Kräfte sind so groß, dass es dabei zu einer Beschädigung des Photopolymerfilms kommen kann. Folglich ist die Substratfolie V1 nicht zur Lösung der erfindungsgemäßen Aufgabe geeignet, was sich bereits aus der Betrachtung der Differenz der L-Werte ergab.

**Patentansprüche**

1. Verbund umfassend ein Substrat und einen Photopolymerfilm, die zumindest abschnittsweise lösbar miteinander verbunden sind, wobei das Substrat Polyethylenterephthalat und der Photopolymerfilm dreidimensional vernetzte Polyurethanmatrixpolymere, ein Schreibmonomer und einen Photoinitiator enthält, **dadurch gekennzeichnet, dass** das Substrat nach einer siebentägigen Inkubation bei 23° C in einer 0,5 volumenprozentigen Butylacetat-Lösung des Farbstoffs der Formel (I)

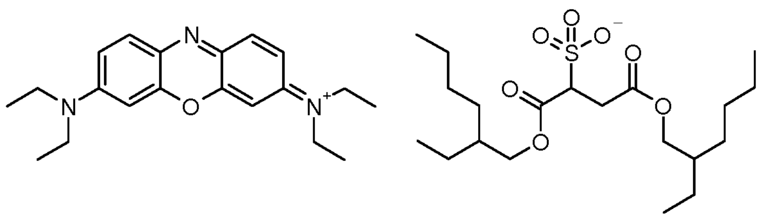

Formel (I)

einen L-Wert L1 und vor der Inkubation einen L-Wert von L0 aufweist, wobei die L-Werte durch CieLAB-Messungen bestimmt sind und die Differenz der L-Werte L1 und L0 der Formel (II)

$$L1\text{-}L0 < -0{,}25 \quad \text{(Formel II)}$$

genügt.

2. Verbund nach Anspruch 1, **dadurch gekennzeichnet, dass** die Differenz der L-Werte L1 und L0 der Formel (III)

$$L1\text{-}L0 \leq -0{,}30 \quad \text{(Formel III)}$$

genügt.

3. Verbund nach einem der Ansprüche 1 oder 2, **dadurch gekennzeichnet, dass** das Substrat eine Folie und insbesondere eine Folie mit einer Dicke von 10 µm bis 375 µm, bevorzugt von 19 µm bis 175 µm und besonders bevorzugt von 30 µm bis 100 µm ist.

4. Verbund nach einem der Ansprüche 1 bis 3, **dadurch gekennzeichnet, dass** der Photopolymerfilm eine Dicke von 5 µm bis 100 µm, bevorzugt von 5 µm bis 50 µm und besonders bevorzugt von 10 µm bis 28 µm aufweist.

5. Verbund nach einem der Ansprüche 1 bis 4, **dadurch gekennzeichnet, dass** der Photopolymerfilm von dem Substrat mit einer Abzugskraft von 0,05 bis 0,75 N/10 mm, bevorzugt von 0,08 bis 0,5 N/ 10 mm und besonders bevorzugt von 0,1 bis 0,25 N/ 10 mm ablösbar ist, wobei die Abzugskraft gemäß DIN-Norm EN ISO 11339 gemessen ist.

6. Verbund nach einem der Ansprüche 1 bis 5, **dadurch gekennzeichnet, dass** das Substrat eine Oberflächenspannung von > 27 mN/m, bevorzugt von ≥ 28 mN/m und ≤ 42,5 mN/m und besonders bevorzugt von ≥ 30 mN/m und ≤ 40 mN/m aufweist.

7. Verbund nach einem der Ansprüche 1 bis 6, **dadurch gekennzeichnet, dass** das Substrat eine Oberflächenrauigkeit von Rz ≤ 600 nm, bevorzugt von Rz ≤ 400 nm und besonders bevorzugt von Rz ≤ 300 nm aufweist.

8. Verbund nach einem der Ansprüche 1 bis 7, **dadurch gekennzeichnet, dass** das Schreibmonomer wenigstens ein mono- und / oder ein multifunktionales Schreibmonomer, bevorzugt wenigstens ein mono- und /oder multifunktionelle Acrylat-Schreibmonomere und besonders bevorzugt wenigstens ein monofunktionelles und / oder ein multifunktionelles Urethan(meth)acrylat umfasst oder daraus besteht.

9. Verbund nach einem der Ansprüche 1 bis 8, **dadurch gekennzeichnet, dass** der Photopolymerfilm Urethane der allgemeinen Formel (IV)

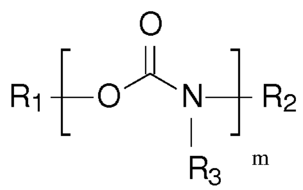

(IV)

enthält, in der m ≥ 1 und m ≤ 8 ist und $R_1$ ein linearer, verzweigter, cyclischer oder heterocyclischer unsubstituierter oder gegebenenfalls auch mit Heteroatomen substituierter organischer Rest und / oder $R_2$, $R_3$ unabhängig voneinander Wasserstoff sind, wobei bevorzugt mindestens einer der Reste $R_1$, $R_2$, $R_3$ mit wenigstens einem Fluoratom substituiert ist und besonders bevorzugt $R_1$ ein organischer Rest mit mindestens einem Fluoratom und ganz besonders bevorzugt $R_3$ ein linearer, verzweigter, cyclischer oder heterocyclischer unsubstituierter oder gegebenenfalls auch mit Heteroatomen wie beispielsweise Fluor substituierter organischer Rest ist.

10. Verbund nach einem der Ansprüche 1 bis 9, **dadurch gekennzeichnet, dass** in den Photopolymerfilm ein Hologramm einbelichtet ist.

**11.** Verfahren zur Herstellung eines Verbundes gemäß einem der Ansprüche 1 bis 10, **dadurch gekennzeichnet, dass** eine Photopolymerformulierung umfassend eine Polyisocyanat-Komponente, eine isocyanatreaktive Komponente, ein Schreibmonomer und einen Photoinitiator auf das Substrat aufgebracht und zum Photopolymerfilm ausgehärtet wird.

**12.** Verfahren zur Herstellung eines isolierten Photopolymerfilms, bei dem bei einem Verbund gemäß einem der Ansprüche 1 bis 10 der Photopolymerfilm und das Substrat vollständig voneinander getrennt werden.

## Claims

**1.** Assembly comprising a substrate and a photopolymer film, which are joined to one another partably at least in sections, the substrate comprising polyethylene terephthalate, and the photopolymer film comprising three-dimensionally crosslinked polyurethane matrix polymers, a writing monomer and a photoinitiator, **characterized in that** the substrate, after seven-day incubation at 23°C in a 0.5 volume per cent butyl acetate solution of the dye of formula (I)

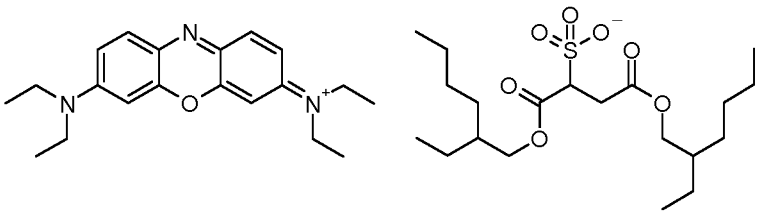

formula (I),

has an L value L1 and before the incubation an L value of L0, the L values being determined by CieLAB measurements, and the difference between the L values L1 and L0 satisfying the formula (II)

$$L1-L0 < -0.25 \quad \text{(formula II)}.$$

**2.** Assembly according to Claim 1, **characterized in that** the difference between the L values L1 and L0 satisfies the formula (III)

$$L1-L0 \leq -0.30 \quad \text{(formula III)}.$$

**3.** Assembly according to either of Claims 1 and 2, **characterized in that** the substrate is a foil, and more particularly a foil having a thickness of 10 μm to 375 μm, preferably of 19 μm to 175 μm and more preferably of 30 μm to 100 μm.

**4.** Assembly according to any of Claims 1 to 3, **characterized in that** the photopolymer film has a thickness of 5 μm to 100 μm, preferably of 5 μm to 50 μm and more preferably of 10 μm to 28 μm.

**5.** Assembly according to any of Claims 1 to 4, **characterized in that** the photopolymer film is detachable from the substrate with a peel force of 0.05 to 0.75 N/10 mm, preferably of 0.08 to 0.5 N/10 mm and more preferably of 0.1 to 0.25 N/10 mm, the peel force being measured in accordance with DIN Standard EN ISO 11339.

**6.** Assembly according to any of Claims 1 to 5, **characterized in that** the substrate has a surface tension of > 27 mN/m, preferably of ≥ 28 mN/m and ≤ 42.5 mN/m and more preferably of ≥ 30 mN/m and ≤ 40 mN/m.

**7.** Assembly according to any of Claims 1 to 6, **characterized in that** the substrate has a surface roughness of Rz ≤ 600 nm, preferably of Rz ≤ 400 nm and more preferably of Rz ≤ 300 nm.

**8.** Assembly according to any of Claims 1 to 7, **characterized in that** the writing monomer comprises or consists of at least one mono- and/or one polyfunctional writing monomer, preferably at least one mono- and/or polyfunctional

acrylate writing monomer and more preferably at least one monofunctional and/or one polyfunctional urethane (meth)acrylate.

**9.** Assembly according to any of Claims 1 to 8, **characterized in that** the photopolymer film comprises urethanes of the general formula (IV)

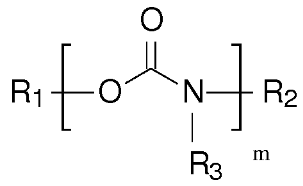

(IV)

in which m is ≥ 1 and m is ≤ 8 and $R_1$ is a linear, branched, cyclic or heterocyclic organic radical, unsubstituted or else optionally substituted by heteroatoms, and/or $R_2$ and $R_3$ independently of one another are hydrogen, with preferably at least one of the radicals $R_1$, $R_2$ and $R_3$ being substituted by at least one fluorine atom, and more preferably $R_1$ being an organic radical having at least one fluorine atom and very preferably $R_3$ being a linear, branched, cyclic or heterocyclic organic radical which is unsubstituted or else optionally substituted by heteroatoms, such as a fluorine-substituted organic radical, for example.

**10.** Assembly according to any of Claims 1 to 9, **characterized in that** a hologram has been exposed into the photopolymer film.

**11.** Method for producing an assembly according to any of Claims 1 to 10, **characterized in that** a photopolymer formulation comprising a polyisocyanate component, an isocyanate-reactive component, a writing monomer and a photoinitiator is applied to the substrate and cured to form the photopolymer film.

**12.** Method for producing an isolated photopolymer film, wherein the photopolymer film and the substrate of an assembly according to any of Claims 1 to 10 are separated completely from one another.

**Revendications**

**1.** Composite comprenant un substrat et un film photopolymère, qui sont reliés l'un avec l'autre de manière amovible au moins par sections, le substrat contenant du polyéthylène téréphtalate et le film photopolymère contenant des polymères de matrice de polyuréthane réticulés tridimensionnellement, un monomère d'écriture et un photoinitiateur, **caractérisé en ce que** le substrat présente après 7 jours d'incubation à 23 °C dans une solution d'acétate de butyle à 0,5 pour cent en volume du colorant de formule (I)

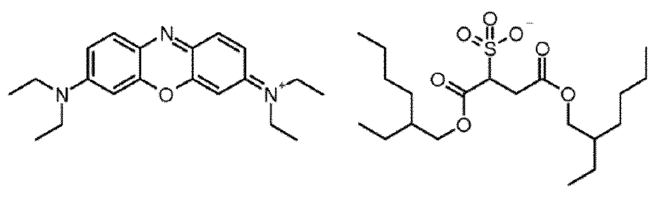

Formule (I)

une valeur L de L1 et avant l'incubation une valeur L de L0, les valeurs L étant déterminées par des mesures CieLAB et la différence entre les valeurs L L1 et L0 satisfaisant la formule (II) :

$$L1-L0 < -0,25 \quad \text{(Formule II)}.$$

**2.** Composite selon la revendication 1, **caractérisé en ce que** la différence entre les valeurs L L1 et L0 satisfait la formule (III) :

$$L1-L0 \leq -0,30 \quad \text{(Formule III).}$$

3. Composite selon l'une quelconque des revendications 1 ou 2, **caractérisé en ce que** le substrat est une feuille et notamment une feuille d'une épaisseur de 10 μm à 375 μm, de préférence de 19 μm à 175 μm et de manière particulièrement préférée de 30 μm à 100 μm.

4. Composite selon l'une quelconque des revendications 1 à 3, **caractérisé en ce que** le film photopolymère présente une épaisseur de 5 μm à 100 μm, de préférence de 5 μm à 50 μm et de manière particulièrement préférée de 10 μm à 28 μm.

5. Composite selon l'une quelconque des revendications 1 à 4, **caractérisé en ce que** le film photopolymère peut être décollé du substrat avec une force de retrait de 0,05 à 0,75 N/10 mm, de préférence de 0,08 à 0,5 N/10 mm et de manière particulièrement préférée de 0,1 à 0,25 N/10 mm, la force de retrait étant mesurée selon la norme DIN EN ISO 11339.

6. Composite selon l'une quelconque des revendications 1 à 5, **caractérisé en ce que** le substrat présente une tension de surface > 27 mN/m, de préférence ≥ 28 mN/m et ≤ 42,5 mN/m et de manière particulièrement préférée ≥ 30 mN/m et ≤ 40 mN/m.

7. Composite selon l'une quelconque des revendications 1 à 6, **caractérisé en ce que** le substrat présente une rugosité de surface Rz ≤ 600nm, de préférence Rz ≤ 400 nm et de manière particulièrement préférée Rz ≤ 300 nm.

8. Composite selon l'une quelconque des revendications 1 à 7, **caractérisé en ce que** le monomère d'écriture comprend au moins un monomère d'écriture mono- et/ou multifonctionnel, de préférence au moins un monomère d'écriture acrylate mono- et/ou multifonctionnel et de manière particulièrement préférée au moins un (méth)acrylate d'uréthane monofonctionnel et/ou multifonctionnel, ou en est constitué.

9. Composite selon l'une quelconque des revendications 1 à 8, **caractérisé en ce que** le film photopolymère contient des uréthanes de formule générale (IV) :

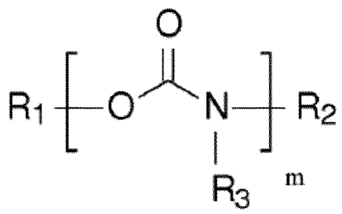

(IV)

dans laquelle m ≥ 1 et m ≤ 8, et $R_1$ est un radical organique linéaire, ramifié, cyclique ou hétérocyclique non substitué ou éventuellement également substitué avec des hétéroatomes, et/ou $R_2$, $R_3$ sont indépendamment l'un de l'autre l'hydrogène, au moins un des radicaux $R_1$, $R_2$, $R_3$ étant de préférence substitué avec au moins un atome de fluor, et $R_1$ étant de manière particulièrement préférée un radical organique contenant au moins un atome de fluor, et $R_3$ étant de manière tout particulièrement préférée un radical organique linéaire, ramifié, cyclique ou hétérocyclique non substitué ou éventuellement également substitué avec des hétéroatomes, tels que par exemple fluor.

10. Composite selon l'une quelconque des revendications 1 à 9, **caractérisé en ce qu'**un hologramme est exposé dans le film photopolymère.

11. Procédé de fabrication d'un composite selon l'une quelconque des revendications 1 à 10, **caractérisé en ce qu'**une formulation de photopolymère comprenant un composant polyisocyanate, un composant réactif avec les isocyanates, un monomère d'écriture et un photoinitiateur est appliquée sur le substrat et durcie en le film photopolymère.

12. Procédé de fabrication d'un film photopolymère isolé, selon lequel le film photopolymère et le substrat sont entièrement séparés l'un de l'autre dans un composite selon l'une quelconque des revendications 1 à 10.

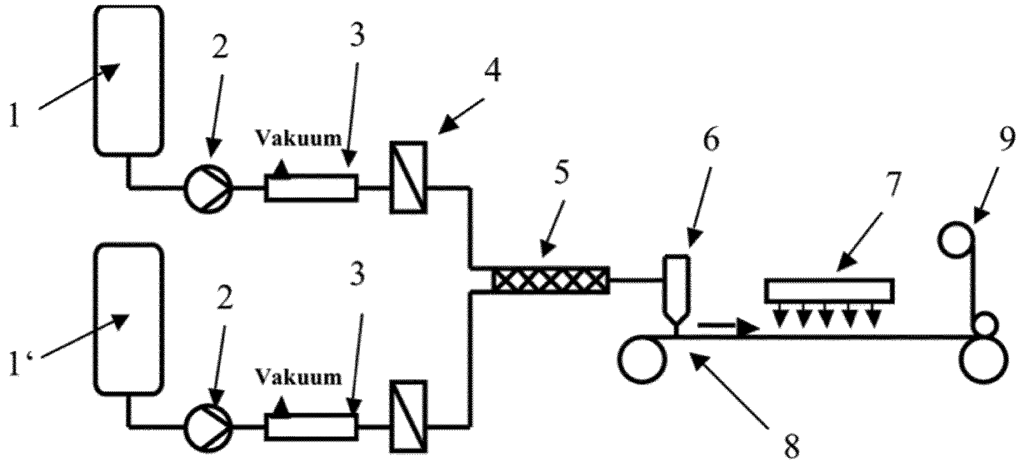


**Figur 1**

Figur 1 zeigt schematisch den Aufbau der Folienbeschichtungsanlage zur Herstellung der Photopolymerfilme.

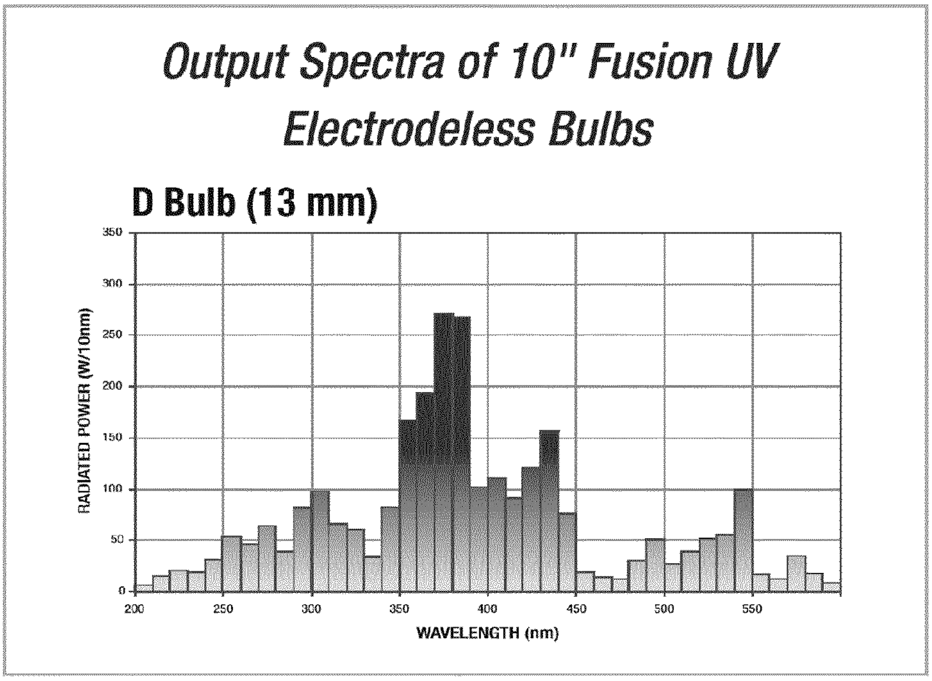


**Figur 2**

Figur 2 zeigt das Spektrum einer zum Bleichen verwendeten UV-Lampe (Herstellerangabe).

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2011067057 A
- WO 2010037515 A1
- JP 2010240944 A
- EP 0223587 A
- WO 2012062655 A


### In der Beschreibung aufgeführte Nicht-Patentliteratur


- Azine Dyes. **H. BERNETH.** Ullmann's Encyclopedia of Industrial Chemistry. Wiley-VCH Verlag, 2008
- **H. BERNETH.** Ullmann's Encyclopedia of Industrial Chemistry, Methine Dyes and Pigments. Wiley-VCH Verlag, 2008
- Triarylmethane and Diarylmethane Dyes. **T. GESSNER ; U. MAYER.** Ullmann's Encyclopedia of Industrial Chemistry. Wiley-VCH Verlag, 2000
- *J. Comput. Aid. Mol. Des.,* 2005, vol. 19, 453
- *Virtual Computational Chemistry Laboratory, http://www.vcclab.org berechnet*
- **CUNNINGHAM et al.** *RadTech'98 North America UV/EB Conference Proceedings,* 19. April 1998
- Chemistry & Technology of UV & EB Formulations For Coatings. Inks & Paints. SITA Technology, 1991, vol. 3, 61-328